# EUROPÄISCHE PATENTSCHRIFT

(11) **EP 2 521 806 B1**
(45) Veröffentlichungstag und Bekanntmachung des Hinweises auf die Patenterteilung: **14.08.2019**
(21) Anmeldenummer: 11733814.5
(22) Anmeldetag: 14.06.2011
(51) Int. Cl.: C30B 29/40, C30B 33/00, C30B 33/08, B23K 26/40, B23K 26/06, C30B 33/06, H01L 21/20, H01L 21/78, H01L 21/268, H01L 21/306, H01L 29/20, B23K 26/53, B23K 103/00, B23K 26/0622

(54) **VERFAHREN ZUM ABTRENNEN EINER SUBSTRATSCHEIBE**
METHOD FOR SLICING A SUBSTRATE WAFER
PROCÉDÉ DE SÉPARATION D'UNE PLAQUETTE DE SUBSTRAT

(30) Priorität: 22.06.2010 DE 102010030358
(43) Veröffentlichungstag der Anmeldung: 14.11.2012
(73) Patentinhaber: Osram Opto Semiconductors Gmbh, 93055 Regensburg (DE)
(72) Erfinder: WAGNER, Ralph, 93073 Neutraubling (DE)
(74) Vertreter: Paul, Benjamin
(86) Internationale Anmeldenummer: PCT/EP2011/059792
(87) Internationale Veröffentlichungsnummer: WO 2011/160977

(56) Entgegenhaltungen:
- WO-A1-2011/069735
- DE-B3-102007 018 080
- JP-A- 2006 245 498
- DIRK WORTMANN ET AL: "Micro- and nanostructures inside sapphire by fs-laser irradiation and selective etching", OPTICS EXPRESS, Bd. 16, Nr. 3, 1. Januar 2008 (2008-01-01) , Seite 1517, XP55005804, ISSN: 1094-4087, DOI: 10.1364/OE.16.001517 in der Anmeldung erwähnt

## Beschreibung

Die vorliegende Erfindung betrifft ein Verfahren zum Abtrennen einer Halbleiterschicht aus einem Halbleitereinkristall.

In der Halbleitertechnologie werden häufig dünne einkristalline Halbleiterschichten benötigt. Dies ist beispielsweise der Fall in der Herstellung von einem optoelektronischen Bauelement, wie einer lichtemittierenden Diode (LED). Eine LED wird beispielsweise über ein Dünnschichtverfahren hergestellt, bei dem eine dünne Schicht eines Halbleiters auf einem Träger, beispielsweise einem Saphirglas abgeschieden wird. Dies geschieht regelmäßig durch ein epitaktisches Aufwachen des Halbleitermaterials. Die so aufgebrachte dünne Schicht wird auch als Epitaxieschicht bezeichnet. Verfahren dazu sind dem Fachmann beispielsweise aus dem Dokument [1] bekannt. Das Abscheiden des Halbleitermaterials, beispielsweise von Galliumnitrid (GaN) oder Galliumarsenid (GaAs), besitzt durch das Aufwachsen auf ein Material mit anderen Strukturkonstanten Einschränkungen in der Qualität der erhaltenen Kristallstruktur. So entstehen beispielsweise Versetzungen bzw. Fehlstellen in dem aufgewachsenen Halbleitermaterial. Häufig wird deshalb zunächst auf dem Träger eine Pufferschicht (*buffer layer*) aufgebracht, die bereits aus dem Halbleitermaterial der Epitaxieschicht besteht. Jedoch weist auch die aufgewachsene Pufferschicht häufig keine durchgehend gleichmäßige Kristallstruktur auf.

Bei der Herstellung von Bauelementen in einer dünnen Halbleiterschicht ist jedoch eine Kristallstruktur mit möglichst wenigen Fehlstellen wünschenswert. Insoweit wird auch von einer guten Kristallqualität gesprochen

Aus dem Dokument [3] sind ein Verfahren und eine Vorrichtung zur Herstellung von dünnen Scheiben oder Filmen aus einem Halbleiterkörper bekannt. Dabei wird ein Laser als Schneidevorrichtung verwendet.

Aus dem Dokument [4] sind ein Verfahren und eine Vorrichtung für ein Laserabhebeverfahren mit einem Strahlteiler bekannt.

Der vorliegenden Erfindung liegt das Problem zugrunde, ein Verfahren bereitzustellen, mit der eine dünne einkristalline Halbleiterschicht mit guter Kristallqualität erzeugt werden kann.

Dieses Problem wird durch das Verfahren zum Abtrennen einer Halbleiterschicht aus einem Halbleitereinkristall gemäß dem Patentanspruch 1 gelöst.

Weiterbildungen und vorteilhafte Ausgestaltungen des optoelektronischen Bauelements sind in den abhängigen Patentansprüchen angegeben.

### BEISPIELHAFTE AUSFÜHRUNGSFORMEN

Verschiedene Ausführungsformen des Verfahrens weisen die folgenden Schritte auf:
- Bereitstellen eines Halbleitereinkristalls mit einheitlicher Kristallstruktur;
- Lokales Modifizieren der Kristallstruktur innerhalb einer Trennebene in dem Halbleitereinkristall in einen veränderten Gefügezustand durch Bestrahlen mittels eines Lasers; wobei die Laserstrahlung in einen punktförmigen Bereich in der Trennebene fokussiert wird;
- Entfernen der modifizierten Trennebene durch selektives Ätzen.

Halbleitereinkristalle können durch eine Vielzahl unterschiedlicher Verfahren erzeugt werden. Beispielsweise werden Halbleitereinkristalle durch ein Ziehen aus einer Schmelze erzeugt. Sie können anschließend in einzelne Scheiben (*wafer*) gesägt werden, die wiederum jeweils einen Halbleitereinkristall darstellen. So können Halbleitereinkristalle mit guter Kristallqualität bzw. einer einheitlichen Kristallstruktur bereitgestellt werden. Solche Halbleitereinkristalle dienen häufig bereits als Grundlage einer weiteren Bearbeitung zu einem Halbleiterbauelement. Ein irradiation and selective etching," Opt. Express 16, 1517-1522 (2008),
[3] DE 10 2007 018 080,
[4] WO 2011/ 069 735 A1.
Halbleitereinkristalls. Durch das kurzzeitige Einwirken großer Strahlungsintensität wird das Gefüge in der Kristallstruktur lokal verändert. Dabei wird ein Laser verwendet, um eine große Strahlungsintensität einer bestimmten Wellenlänge in die Kristallstruktur einzubringen. Durch die große Strahlungsintensität kann das Halbleitermaterial beispielsweise lokal aufgeschmolzen oder die Kristallstruktur durch andere Prozesse verändert werden. Bei einem anschließenden Abkühlen entsteht ein verändertes Gefüge, in dem das Halbleitermaterial beispielsweise einen amorphen Zustand, einen polykristallinen Zustand oder ein Gemisch aus beiden Zuständen annimmt.

Der Halbleitereinkristall ist durch die Einwirkung des Lasers derart modifiziert, dass er im Bereich der Trennebene ein verändertes Gefüge aufweist. Durch ein selektives Ätzen wird der Halbleitereinkristall im Bereich des veränderten Gefüges stärker geätzt als im Bereich der erhaltenen Kristallstruktur. Damit wird der Halbleitereinkristall in der Trennebene durchtrennt. Es entsteht eine Halbleiterschicht, die von dem Halbleitereinkristall abgenommen werden kann. Die Halbleiterschicht weist ihrerseits eine Kristallstruktur mit guter Qualität auf. Zudem kann die Schicht durch eine geeignete Wahl der Lage der Trennebene in einer gewünschten Dicke oder Orientierung der Kristallebenen erzeugt werden.

In einer Ausführungsform wird eine an die Trennebene grenzende Oberfläche der Halbleiterschicht poliert. Damit werden Ungleichmäßigkeiten ausgeglichen, die bei dem Ätzprozess entstehen können. So kann die Oberfläche beispielsweise durch die Modifikation mittels Laserstrahlung eine gewisse Rauhigkeit aufweisen. Ebenso ist es möglich, dass aufgrund des selektiven Ätzens in einer dünnen Trennebene eine konkave Oberfläche der Halbleiterschichterzeugt wird. Durch das Polieren kann eine möglichst ebene und glatte Oberfläche der Halbleiterschicht erzeugt werden. Dazu sind beispielsweise Verfahren, wie ein chemisch-mechanisches Polieren (*chemical mechanical polishing* oder *CMP*) denkbar.

In einer Ausführungsform erfolgt das Modifizieren des Halbleitereinkristalls durch fokussiertes Einstrahlen von durch den Laser emittierter Laserstrahlung über die Oberseite des Halbleitereinkristalls. Damit kann die Wirkungsentfaltung des Lasers kontrolliert im Bereich der Trennebene erfolgen. Insbesondere können eine geeignete numerische Apertur oder auch eine durch die Dicke der Halbleiterschicht erforderliche Deckglaskorrektur kontrolliert eingestellt werden.

In einer Ausführungsform umfasst die Laserstrahlung eine Pikosekunden- oder Femtosekundenlaserstrahlung. Dadurch können kontrolliert derart hohe Strahlungsleistungen in die Trennebene eingebracht werden, dass eine Modifikation der Kristallstruktur beispielsweise in eine amorphe oder polykristalline Struktur erfolgt.

In einer Ausführungsform wird der Fokus der Laserstrahlung rasterartig über die gesamte Trennebene eingebracht. Dabei kann die Trennebene sukzessive modifiziert werden, so dass eine durchgehende modifizierte Trennebene erhalten wird, die sich durchgehend zwischen der abzutrennenden Halbleiterschicht und dem übrigen Halbleitereinkristall erstreckt.

In einer Ausführungsform wird die Laserstrahlung über eine Optik mit einer numerischen Apertur von mehr als 0,3, insbesondere von mehr als 0,5, in den Bereich der Trennebene fokussiert. Durch die numerische Apertur wird die Fokusgröße der eingebrachten Laserstrahlung mitbestimmt. Durch die hohe numerische Apertur wird eine wirksame Fokussierung, d.h. ein geringer Fokusradius (Airy-Disk-Radius) erzielt. Die Modifikation in der Trennebene führt daher zu einer lokal begrenzten Gefügeveränderung im Halbleitereinkristall. Dadurch wird durch das genannte Verfahren beim Abtrennen der Halbleiterschicht ein möglichst geringer Anteil des Halbleitermaterials verbraucht. Dies ist gerade bei aufwändig oder nur mit hohen Kosten bereitzustellenden Halbleitermaterialien ein erheblicher Vorteil gegenüber bekannten Verfahren, wie beispielsweise einem Sägen des Halbleitereinkristalls.

In einer Ausführungsform erfolgt das Entfernen der modifizierten Trennebene durch ein nasschemisches Verfahren. Das nasschemische Verfahren kann beispielsweise durch ein Eintauchen in einer reaktiven Säure oder Lauge erfolgen. Dabei erfolgt in dem Halbleitereinkristall ein selektives Ätzen, wobei die reaktive Säure bzw. Lauge stärker mit der modifizierte Trennebene reagiert als mit dem übrigen Halbleitereinkristall. Geeignete nasschemische Verfahren sind dem Fachmann in Verbindung mit den unterschiedlichsten Halbleitermaterialien bekannt. Es ist aber ebenso möglich trockenchemische Verfahren oder andere geeignete Ätzverfahren zu verwenden.

In einer Ausführungsform umfasst das nasschemische Verfahren die Verwendung eines Benetzungsmittels. Dadurch kann die in dem nasschemischen Verfahren verwendete Ätzlösung besser in dünne Kanäle in den Halbleitereinkristall eintreten, so dass gerade auch eine sehr dünne modifizierte Trennebene entfernt werden kann, ohne dass durch zulange Reaktionszeiten der Halbleitereinkristall unnötig mit der Ätzlösung des nasschemischen Verfahrens reagiert.

In einer Ausführungsform wird ein Träger an der Oberseite des Halbleitereinkristalls befestigt. Ein solcher Träger ist beispielsweise ein Saphirglas, ein Siliziumsubstrat oder ein anderes geeignetes Material, das zur mechanischen Stabilisierung der abzutrennenden Halbleiterschicht dient. In einer besonderen Ausführungsform wird der Träger vor einem nasschemischen Ätzen aufgebracht, so dass die Halbleiterschicht anschließend leicht abgenommen und weiterverarbeitet werden kann. Ebenso kann das Modifizieren der Trennebene nach einem Befestigen des Trägers erfolgen. In diesem Fall können der Träger sowie ein Befestigungsmittel transparent im Bereich der verwendeten Laserstrählung sein. Alternativ kann der Halbleitereinkristall über eine dem Träger gegenüberliegende Seite bestrahlt werden. Typischerweise können Befestigungsmittel wie ein Lot, beispielsweise ein Zinnlegierung, oder ein Klebstoff, beispielsweise ein Epoxydharz, verwendet werden.

### KURZE BESCHREIBUNG DER ZEICHNUNGEN

Verschiedene Ausführungsbeispiele des Verfahrens zum Abtrennen einer Halbleiterschicht aus einem Halbleitereinkristall werden im Folgenden anhand der Zeichnungen näher erläutert. In den Figuren gehen die erste(n) Ziffer(n) eines Bezugszeichens die Figur an, in dem das Bezugszeichen zuerst verwendet wird. Gleiche Bezugszeichen werden für gleichartige oder gleichwirkende Elemente bzw. Eigenschaften in allen Figuren verwendet.

Es zeigen
**Fig. 1a** bis **Fig. 1d** eine schematische Darstellung von Verfahrensschritten beim Abtrennen einer Halbleiterschicht aus einem Halbleitereinkristall gemäß einem ersten Ausführungsbeispiel und
**Fig. 2a** bis **Fig. 2b** eine schematische Darstellung von Verfahrensschritten beim Abtrennen einer Halbleiterschicht aus einem Halbleitereinkristall gemäß einem zweiten Ausführungsbeispiel.

### ERSTES AUSFÜHRUNGSBEISPIEL EINES VERFAHRENS ZUM ABTRENNEN EINER HALBLEITERSCHICHT

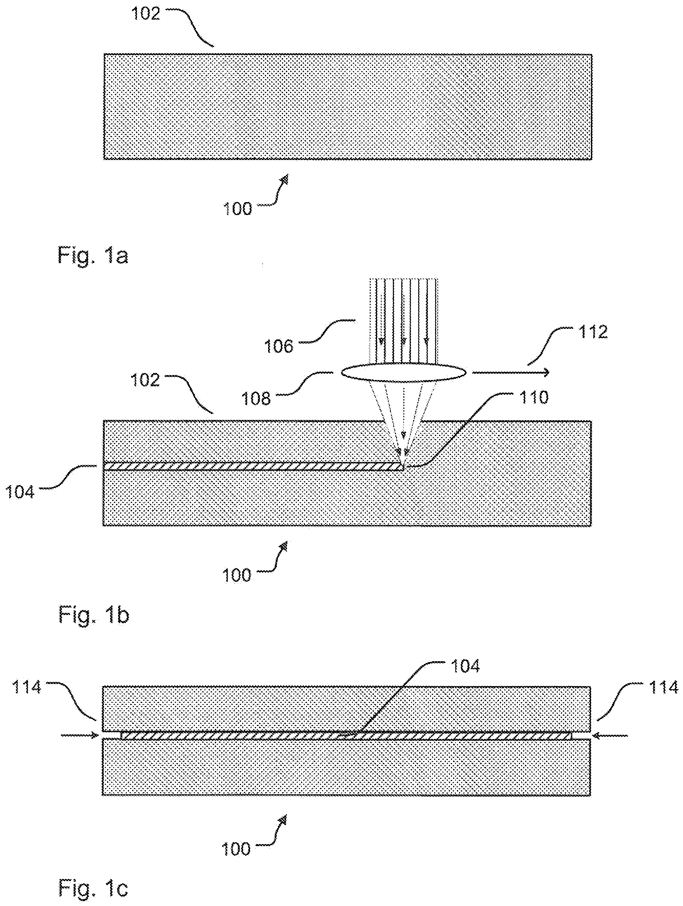

**Fig. 1a** bis **Fig. 1d** zeigen eine schematische Darstellung von Verfahrensschritten beim Abtrennen einer Halbleiterschicht aus einem Halbleitereinkristall gemäß einem ersten Ausführungsbeispiel.

In einem ersten Verfahrenschritt wird ein in **Fig. 1a** dargestellter Halbleiterkristall 100 bereitgestellt. Der Halbleiterkristall 100 ist ein Einkristall eines Halbleitermaterials, insbesondere eine III-V Halbleitermaterials, wie beispielsweise GaN oder GaAs. In Zusammenhang mit der Herstellung von optoelektronischen Bauelementen werde auch anderen, beispielsweise Indiumbasierte Halbleitermaterialien verwendet. Der Halbleiterkristall 100 wird beispielsweise als Halbleiterscheibe bzw. *wafer* bereitgestellt. Er weist eine Oberfläche 102 auf.

In eine zweiten Verfahrenschritt, der in der **Fig. 1b** dargestellt ist, wird in dem Halbleiterkristall 100 eine modifizierte Trennebene 104 erzeugt. Dazu wird der Halbleiterkristall 100 einer Laserstrahlung 106 ausgesetzt. Die Laserstrahlung 106 wird über eine geeignete Optik 108 in der Trennebene 104 in einen Fokussierungsbereich 110 fokussiert. Der Fokussierungsbereich 110 weist einen Fokusdurchmesser auf. Der Fokusdurchmesser bestimmt sich aus der Wellenlänge der eingebrachten Laserstrahlung 106 und einer numerischen Apertur der verwendeten Optik 108. Für die Laserstrahlung 106 wird typischerweise eine Pikosekunden- oder Femtosekundenlaserstrahlung verwendet. Damit wird in Pulsen eine sehr hohe Energiedichte in den Halbleitereinkristall 100 eingebracht. Die Kristallstruktur wird dadurch im Fokussierungsbereich 110 lokal zerstört bzw. modifiziert. Bei einer anschließenden Relaxation ins Gleichgewicht entsteht ein verändertes Gefüge des Halbleitermaterials. Beispielsweise erstarrt das Halbleitermaterial in einer amorphen bzw. glasartigen Phase, einer polykristallinen Phase oder als Gemisch aus den genannten Phasen. Eine Modifikation eines Kristallgefüges mittels einer Femtosekundenlaserstrahlung ist für einen Saphirkristall beispielsweise aus dem Dokument [2] bekannt.

Insgesamt ist es vorteilhaft, dass die verwendete Laserstrahlung 106 ohne große Verluste das Halbleitermaterial durchdringen kann. Dazu wird eine Wellenlänge der Laserstrahlung 106 gewählt, für die der Halbleiterkristall 100 weitgehend transparent ist. Eine große Leistungsdichte der Laserstrahlung 106 wird durch die Konzentration auf den Fokussierungsbereich 110 erreicht. Durch nichtlineare Effekte wird die Laserstrahlung 106 im Fokussierungsbereich 110 zumindest teilweise absorbiert. Der Fokussierungsbereich 110 bestimmt dabei auch das Ausmaß der Zerstörung der Kristallstruktur innerhalb des Halbleitereinkristalls 100. Er liegt in der Trennebene 104, wobei ein Fokussierungsfehler beim Durchgang der Laserstrahlung 106 durch das Halbleitermaterial gegebenenfalls mittels einer Deckglaskorrektur in der Optik 108 korrigiert werden kann.

Beispielsweise wird zur Modifikation eines GaN-basierten Halbleiterkristalls 100 eine Laserstrahlung 106 mit einer Wellenlänge zwischen 360 nm und 1300 nm verwendet. In besonders vorteilhaften Ausführungen liegt die Wellenlänge der Laserstrahlung 106 zwischen 750 nm und 1100 nm. Eine typische Pulsdauer für die Femtosekundenlaserstrahlung liegt zwischen 10 fs bis 1000 fs. Eine typische Pulsenergie der Laserstrahlung 106 liegt im Bereich von 0,1 µJ bis 20 µJ. Durch eine numerische Apertur von mehr als 0,3, insbesondere von mehr als 0,5, wird durch bei einem Durchmesser des Fokussierungsbereichs 110 von weniger als 10 µm, insbesondere weniger als 5 µm, eine hinreichende große Leistungsdichte erreicht, um die Kristallstruktur des GaN-basierten Halbleiterkristalls 100 aufzubrechen. Die Größe des Fokussierungsbereichs 110 ist durch die Fokus- bzw. Rayleighlänge bestimmt, die sich aus der verwendeten Numerischen Apertur der verwendeten Optik 108 und der Wellenlänge der verwendeten Laserstrahlung 106 ergibt.

Die Laserstrahlung 106 wird rasterartig über der gesamten Oberfläche 102 in den Halbleiterkristall 100 eingebracht. Dazu wird die Laserstrahlung 106 mitsamt der Optik 108 parallel zu der Oberfläche 102 (angedeutet durch einen Pfeil 112) verschoben. Es wird die Oberfläche 102 derart mit der Laserstrahlung 106 abgetastet, dass der Halbleiterkristall 100 in einer durchgehenden Trennebene 104 modifiziert wird, wobei die Trennebene 104 parallel zu der Oberfläche 102 angeordnet ist. Jedoch ist es auch denkbar, dass die Laserstrahlung 106 in anderer geeigneter Weise, beispielsweise über eine ortsfeste Optik 108, die Oberfläche 102 abtastet oder dass die Trennebene 104 geneigt zu der Oberfläche 102 verläuft. Wichtig ist es, dass der Fokussierungsbereich 110 jederzeit innerhalb der gewünschten Trennebenen 104 liegt.

Sobald eine modifizierte Trennebene 104 durchgehend innerhalb des Halbleiterkristalls 100 erzeugt wurde, wird das modifizierte Halbleitermaterial entfernt. Dies geschieht, wie in der **Fig. 1c** dargestellt, durch ein selektives Ätzen des Halbleitereinkristalls 100. Dabei kann der der Halbleiterkristall 100 beispielsweise nasschemisch geätzt werden, indem er einer Ätzlösung ausgesetzt wird. Insbesondere wird an die Seitenflächen 114 des Halbleiterkristalls 100 eine Ätzlösung aufgebracht. Beispielsweise wird der Halbleiterkristall 100 in ein Säurebad getunkt oder mit einer Ätzlösung umspült. So kann ein GaN-basierten Halbleiterkristalls 100 in Säure, wie beispielsweise Flusssäure (HF), oder in Lauge, wie beispielsweise Kaliumhydroxid (KOH), getaucht werden. Bei dem selektiven Ätzen wird das modifizierte Halbleitermaterial in der Trennebenen 104 mit einer erheblich höheren Ätzrate als das übrige Halbleitermaterial aus dem Halbleitereinkristall 100 entfernt. Bei den oben beispielhaft genannten System liegt das Verhältnis der Ätzraten bei einem Faktor von mehr als tausend (1.000) bis hin zu zehntausend (10.000).

Vorteilhaft ist eine gute Benetzung der modifizierten Trennebene 104 während des selektiven Ätzens. Dazu muss die Ätzlösung in die entstehenden Kanäle in der Trennebene 104 eintreten und auch gut aus diesen ausgespült werden können. Vorteilhafterweise kann der Ätzlösung ein Benetzungsmittel, wie etwas Sulfonsäure oder einem Fluortensid, zugefügt werden. Damit wird die Oberflächenspannung der Ätzlösung herabgesetzt und sie kann besser in dünne Kapillare oder Kanäle eindringen und die modifizierte Trennebene 104 gut benetzen.

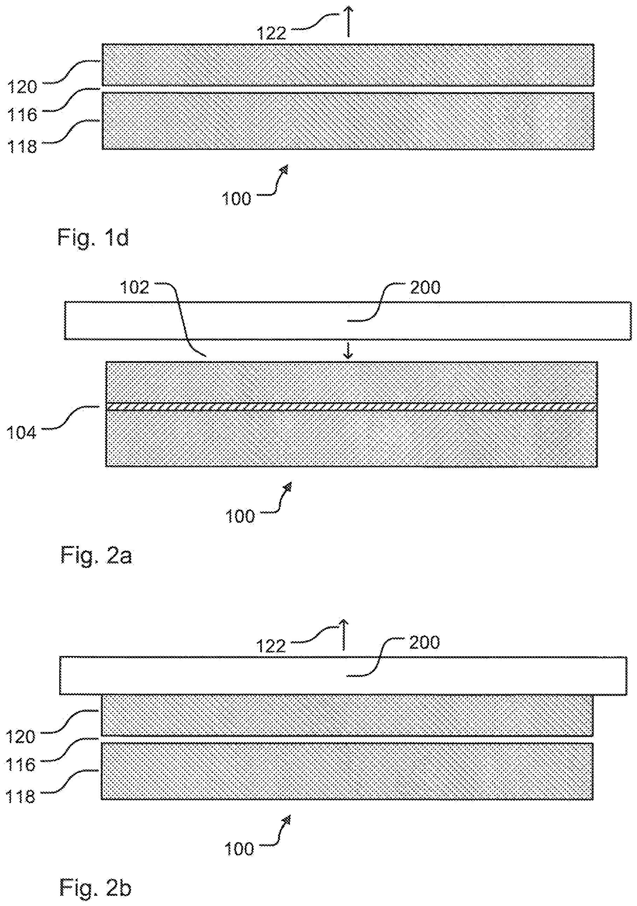

Durch das selektive Ätzen wird der Halbleiterkristall 100 im Bereich der Trennebene 104 getrennt. Wie in **Fig. 1d** dargestellt, entsteht so in dem Halbleitereinkristall 100 eine Trenngraben 116, der den verbleibenden Halbleiterkörper 118 von einer Halbleiterschicht 120 abtrennt. Da der Trenngraben 116 durchgehend zwischen dem Halbleiterkörper 118 und der Halbleiterschicht 120 verläuft, kann die Halbleiterschicht 120, beispielsweise durch ein Ansaugen, in Richtung einer Normalen 122 von dem Halbleiterkörper 118 abgenommen werden.

Für das Ablösen einer Vielzahl von Einzelschichten aus einem Halbleiterkristall 100 ist es besonders vorteilhaft, wenn auf den Oberflächen des Halbleiterkörpers eine Ätzstoppschicht aufgebracht wird, und lediglich die Randseiten oder die Bereiche an den Randseiten des Halbleiterkörpers frei von der Ätzstoppschicht bleiben, in denen die Ätzlösung in die Trennebene eindringen soll. Damit kann eine Zerstörung der Oberflächen durch ein langes und wiederholtes Tauchen in der Ätzlösung vermieden werden.

Das Verfahren ermöglicht damit ein Bereitstellen einer oder mehrerer dünner Halbleiterschichten 120. Die Halbleiterschicht 120 steht für beliebige Anwendung zur Verfügung. Dazu kann die dem Trenngraben 116 zugewandet Seite der Halbleiterschicht 120 durch zusätzliche Prozessschritte, wie beispielsweise mit einem chemisch-mechanischem Polieren (*chemical mechanical polishing* oder *CMP*) und/oder mit einem Temperschritt, planarisiert werden, bzw. können Fehlstellen an der Seite behoben werden. Die Halbleiterschicht 120 kann unterschiedlichen Anwendungen dienen. Sie kann beispielsweise als flexibler Träger dienen. Ebenso kann sie, beispielsweise nachdem sie auf einen mechanisch stabilen Träger aufgebracht wurde, als Aufwachssubstrat bzw. als Epitaxieträger in einem Epitaxieverfahren dienen. Vorteilhaft ist es dabei insbesondere, dass ein Epitaxieträger mit gleicher Kristallstruktur wie die aufgetragenen Epitaxieschichten bereitgestellt werden kann. So kann das Bilden von Fehlstellen oder Versetzungen in der Epitaxieschicht weitgehend vermieden werden.

Es sind auch eine Vielzahl von Variationen des Verfahrens denkbar. In einer möglichen Ausgestaltung werden eine Vielzahl von parallelen Trennebenen mittels der Laserstrahlung modifiziert. So können in einem Ätzprozess eine Vielzahl von Halbleiterschichten abgetrennt werden. Dabei ist es besonders vorteilhaft, zunächst die tiefstliegende Trennebene zu modifizieren und zuletzt die zuoberst liegende Trennebene zu modifizieren, um jeweils einen möglichst homogenen Strahlengang der Laserstrahlung zu gewährleisten. Bei dieser Ausgestaltung wäre es zudem denkbar, wenn auf den Oberflächen des Halbleiterkörpers eine Ätzstoppschicht aufgebracht wird, und lediglich die Randseiten oder die Bereiche an den Randseiten des Halbleiterkörpers frei von der Ätzstoppschicht bleiben, in denen die Ätzlösung in die Trennebenen eindringen soll. In einer anderen Weiterbildung wird nach einem Abtrennen einer Halbleiterschicht eine Oberfläche des verbleibenden Halbleiterkörpers planarisiert, bevor eine weitere Halbleiterschicht mit einem ähnlichen Verfahren abgetrennt wird.

### ZWEITES AUSFÜHRUNGSBEISPIEL EINES VERFAHRENS ZUM ABTRENNEN EINER HALBLEITERSCHICHT

Ein weiteres, bevorzugtes Ausführungsbeispiel wird nachfolgend mit Bezug auf die **Fig. 2a** und die **Fig. 2b** beschrieben. Die **Fig. 2a** und **Fig. 2b** zeigen eine schematische Darstellung von Verfahrensschritten beim Abtrennen einer Halbleiterschicht aus einem Halbleitereinkristall 100. Im wesentlich erfolgt das Verfahren mit den Schritten analog zu dem ersten Ausführungsbeispiel. Wesentlicher Unterschied ist jedoch das Befestigen eines Stützträgers 200 an dem Halbleiterkristall 100, um die Halbleiterschicht 120 besser abheben zu können.

Dabei ist es besonders vorteilhaft, wenn der Stützträger nach einem Modifizieren der Trennebene 104 aufgebracht wird. Dies ist schematisch in der **Fig. 2a** dargestellt. Der Stützträger 200 kann beispielsweise durch ein Verkleben mittels Epoxydharz, durch eine Löten mit einem niederschmelzenden Lot, wie beispielsweise Zinn (Sn), oder ein eutektisches Bonden mit einem AuSn-Lot an der Oberseite 102 des Halbleiterkristalls 100 befestigt sein. Das Anbringen des Stützträgers 200 nach dem Modifizieren der Trennebene 104 hat den Vorteil, dass bei der Wahl des Stützträgers 200 und des Verbindungsmaterials nicht auf besondere optische Eigenschaften, insbesondere auf eine Transparenz im Bereich der Laserstrahlung geachtet werden muss. Auch sind keine aufwändigen optischen Korrekturen notwendig, um den Fokussierungsbereich in die Trennebene 104 zu legen. Jedoch ist es auch möglich, zunächst den Stützträger 200 aufzubringen und anschließend die Trennebene 104 über die gegenüberliegende Seite des Halbleiterkristalls 100 mit Laserstrahlung zu modifizieren.

Als typische Stützträger 200 können ein Saphirglasträger oder auch ein Siliziumträger, beispielsweise in Form eines Siliziumwafers dienen. Bei der Wahl kann ebenfalls darauf geachtet werden, dass sowohl der Stützträger 200 als auch das Verbindungsmaterial einen ähnlichen thermischen Ausdehnungskoeffizienten wie das Halbleitermaterial des Halbleiterkristalls aufweisen. Auch kann darauf geachtet werden, dass eine möglichst langlebige und hohe Haftung zwischen Stützträger 200 und Halbleitermaterial erzielt wird.

Schließlich kann der Stützträger 200 aus einem Material gewählt sein, dass möglichst inert gegenüber der Ätzlösung beim folgenden selektiven Ätzen ist. Nach dem selektiven Ätzen haftet die abgetrennte Halbleiterschicht 120 - wie in der **Fig. 2b** dargestellt - an dem Stützträger 200 und ist von dem verbleibenden Halbleiterkörper 118 durch den herausgebildeten Trenngraben 116 getrennt. Durch ein Anheben des Stützträgers 200 in Richtung 122 der Normalen zur Oberfläche 102 kann die Halbleiterschicht 120 zur weiteren Verarbeitung von dem Halbleiterkristall 100 abgenommen werden. Die Halbleiterschicht 120 steht damit zur weiteren Verarbeitung bereit, wie sie beispielsweise in Zusammenhang mit dem ersten Ausführungsbeispiel beschrieben wurde.

### ABSCHLIESSENDE FESTSTELLUNG

Das Verfahren zum Abtrennen einer Halbleiterschicht aus einem Halbleitereinkristall wurde zur Veranschaulichung des zugrunde liegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso möglich, in Ausführungsbeispielen einzelne dargestellte Merkmale oder besondere Ausgestaltungen wegzulassen oder hinzuzufügen, soweit die allgemeine technische Lehre realisiert bleibt.

### LITERATUR

In diesem Dokument sind die folgenden Veröffentlichungen zitiert:
[1] Nakamura S. und Fasol G.: The blue laser diode: GaN based light emitters and lasers: Berlin; Springer, 1997. Seiten 35 bis 77; ISBN 3-540-61590-3; und
[2] Wortmann D., Gottmann J., Brandt N. und Horn-Solle H., "Micro- and nanostructures inside sapphire by fs-laser irradiation and selective etching," Opt. Express 16, 1517-1522 (2008).

**BEZUGSZEICHENLISTE**

| | |
|---|---|
| Halbleiterkristall | 100 |
| Oberfläche | 102 |
| Trennebene | 104 |
| Laserstrahlung | 106 |
| Optik | 108 |
| Fokussierungsbereich | 110 |
| Richtung | 112 |
| Seitenflächen | 114 |
| Trenngraben | 116 |
| Verbleibender Halbleiterkörper | 118 |
| Halbleiterschicht | 120 |
| Normalenrichtung | 122 |
| Träger | 200 |

## Patentansprüche

1. Verfahren zum Abtrennen einer einkristallinen Halbleiterschicht (116) aus einem Halbleitereinkristall (100) umfassend:
- Bereitstellen eines Halbleitereinkristalls (100) mit einheitlicher Kristallstruktur;
- Lokales Modifizieren der Kristallstruktur innerhalb einer Trennebene (104) in dem Halbleitereinkristall (100) in einen veränderten Gefügezustand durch Bestrahlen mittels eines Lasers (106), wobei die Laserstrahlung in einen punktförmigen Bereich in der Trennebene (104) fokussiert wird;
- Entfernen der modifizierten Trennebene (104) durch selektives Ätzen.

2. Verfahren gemäß Patentanspruch 1 umfassend:
- Polieren einer an die Trennebene (104) grenzenden Oberfläche der Halbleiterschicht.

3. Verfahren gemäß einem der vorangehenden Patentansprüche wobei das Modifizieren durch fokussiertes Einstrahlen von durch den Laser emittierter Laserstrahlung (106) über die Oberseite (102) des Halbleitereinkristalls (100) erfolgt.

4. Verfahren gemäß Patentanspruch 3, wobei die Laserstrahlung eine Pikosekunden- oder Femtosekundenlaserstrahlung umfasst.

5. Verfahren gemäß einem der vorangehenden Patentansprüche, wobei ein Fokus der Laserstrahlung rasterartig über die gesamte Trennebene eingebracht wird.

6. Verfahren gemäß einem der vorangehenden Patentansprüche, wobei die Laserstrahlung über eine Optik mit einer numerischen Apertur von mehr als 0,5, insbesondere von mehr als 0,3, in den Bereich der Trennebene fokussiert wird.

7. Verfahren gemäß einem der vorangehenden Patentansprüche wobei das Entfernen der modifizierten Trennebene durch ein nasschemisches Verfahren erfolgt.

8. Verfahren gemäß Patentanspruch 7, wobei das nasschemische Verfahren die Verwendung eines Benetzungsmittels umfasst.

9. Verfahren gemäß einem der vorangehenden Patentansprüche umfassend:
- Befestigen eines Trägers an der Oberseite des Halbleitereinkristalls.

10. Verfahren gemäß Patentanspruch 9, wobei der Träger während des selektiven Ätzens an der Oberseite des Halbleitereinkristalls befestigt ist.

11. Verfahren gemäß einem der vorangehenden Patentansprüche, wobei der Halbleitereinkristall ein III-V-Halbleitermaterial aufweist.

12. Verfahren gemäß Patentanspruch 11, wobei das III-V-Halbleitermaterial Galliumnitrid aufweist.

## Claims

1. Method for slicing a monocrystalline semiconductor layer (116) from a semiconductor single crystal (100) comprising:
- providing a semiconductor single crystal (100) having a uniform crystal structure;
- locally modifying the crystal structure within a separating plane (104) in the semiconductor single crystal (100) into an altered microstructure state by means of irradiation using a laser (106), wherein the laser radiation is focused into a punctiform region in the separating plane (104);
- removing the modified separating plane (104) by means of selective etching.

2. Method according to Patent Claim 1 comprising:
- polishing a surface of the semiconductor layer which adjoins the separating plane (104).

3. Method according to either of the preceding patent claims, wherein modifying is effected by focused incidence of laser radiation (106) emitted by the laser via the top side (102) of the semiconductor single crystal (100).

4. Method according to Patent Claim 3, wherein laser radiation comprises a picosecond or femtosecond laser radiation.

5. Method according to any of the preceding patent claims, wherein a focus of the laser radiation is introduced in a raster-like fashion over the entire separating plane.

6. Method according to any of the preceding patent claims, wherein the laser radiation is focused into the region of the separating plane via an optical unit having a numerical aperture of more than 0.5, in particular of more than 0.3.

7. Method according to any of the preceding patent claims, wherein removing the modified separating plane is effected by means of a wet-chemical method.

8. Method according to Patent Claim 7, wherein the wet-chemical method comprises the use of a wetting agent.

9. Method according to any of the preceding patent claims comprising:
- fixing a carrier to the top side of the semiconductor single crystal.

10. Method according to Patent Claim 9, wherein the carrier is fixed to the top side of the semiconductor single crystal during selective etching.

11. Method according to any of the preceding patent claims, wherein the semiconductor single crystal comprises a III-V semiconductor material.

12. Method according to Patent Claim 11, wherein the III-V semiconductor material comprises gallium nitride.

## Revendications

1. Procédé pour la séparation d'une couche semi-conductrice monocristalline (116) d'un monocristal semi-conducteur (100) comportant :
- la fourniture d'un monocristal semi-conducteur (100) avec une structure cristalline uniforme ;
- la modification locale de la structure cristalline à l'intérieur d'un plan de séparation (104) dans le monocristal semi-conducteur (100) en un état structural modifié par irradiation au moyen d'un laser (106), dans lequel le rayonnement laser est focalisé en une zone ponctuelle dans le plan de séparation (104) ;
- le retrait du plan de séparation (104) modifié par attaque sélective.

2. Procédé selon la revendication 1 comportant :
- le polissage d'une surface limitrophe du plan de séparation (104) de la couche semi-conductrice.

3. Procédé selon l'une des revendications précédentes, dans lequel la modification s'effectue par projection focalisée d'un rayonnement laser (106) émis par le laser sur la face supérieure (102) du monocristal semi-conducteur (100).

4. Procédé selon la revendication 3, dans lequel le rayonnement laser comporte un rayonnement laser picoseconde ou femtoseconde.

5. Procédé selon l'une des revendications précédentes, dans lequel un foyer du rayonnement laser est introduit à la façon d'une trame sur le plan de séparation global.

6. Procédé selon l'une des revendications précédentes, dans lequel le rayonnement laser est focalisé dans la zone du plan de séparation par.l'intermédiaire d'une optique avec une ouverture numérique de plus de 0,5, en particulier de plus de 0,3.

7. Procédé selon l'une des revendications précédentes, dans lequel le retrait du plan de séparation modifié s'effectue par un procédé chimique humide.

8. Procédé selon la revendication 7, dans lequel le procédé chimique humide comporte l'utilisation d'un agent mouillant.

9. Procédé selon l'une des revendications précédentes comportant :
- la fixation d'un support sur la face supérieure du monocristal semi-conducteur.

10. Procédé selon la revendication 9, dans lequel le support est fixé pendant l'attaque sélective sur la face supérieure du monocristal semi-conducteur.

11. Procédé selon l'une des revendications précédentes, dans lequel le monocristal semi-conducteur comprend un matériau semi-conducteur III-V.

12. Procédé selon la revendication 11, dans lequel le matériau semi-conducteur III-V comprend du nitrure de gallium.
